Europäisches Patentamt

European Patent Office

Office européen des brevets

(11) Veröffentlichungsnummer: **0 503 447 A2**

## EUROPÄISCHE PATENTANMELDUNG

(21) Anmeldenummer: **92103651.3**

(22) Anmeldetag: **03.03.92**

(51) Int. Cl.5: **H01L 39/24**, H01L 39/14, H01L 39/20

(30) Priorität: **09.03.91 DE 4107685**

(43) Veröffentlichungstag der Anmeldung:
**16.09.92 Patentblatt 92/38**

(84) Benannte Vertragsstaaten:
**DE FR GB**

(71) Anmelder: **ABB PATENT GmbH**
**Kallstadter Strasse 1**
**W-6800 Mannheim 1(DE)**

(72) Erfinder: **Abeln, Angelika, Dr.**
**Mannheimer Strasse 10-12**
**W-6940 Weinheim(DE)**
Erfinder: **Jahnke, Bernd, Dr.**
**Gottlob-Kamm-Strasse 11**
**W-6903 Neckargemünd(DE)**

(74) Vertreter: **Rupprecht, Klaus, Dipl.-Ing. et al**
**c/o ABB Patent GmbH, Postfach 10 03 51**
**W-6800 Mannheim 1(DE)**

(54) **Supraleitender Strombegrenzer.**

(57) Die Erfindung bezieht sich auf einen supraleitenden Strombegrenzer (1), der in der Lage ist, große Nennströme zu tragen. Die bisher bekannten supraleitenden Strombegrenzer (1) weisen Leiter (2) aus metallischen Supraleitern auf, für deren Betrieb eine komplizierte Heliumkühlung erforderlich ist. Gegenstand der vorliegenden Patentanmeldung ist ein supraleitender Strombegrenzer (1), dessen elektrischer Leiter (2) ganz oder teilweise aus einem keramischen supraleitenden Material gefertigt ist. Der Leiter (2) ist durch einen Träger (3) vor einer mechanischen Zerstörung geschützt.

Fig. 1

Die Erfindung bezieht sich auf einen supraleitenden Strombegrenzer mit wenigstens einem den Nennstrom tragenden Leiter gemäß dem Oberbegriff des Patentanspruches 1.

Supraleitende Strombegrenzer sind bereits seit vielen Jahren bekannt. Sie sind in der Lage, Nennströme von vielen Ampere zu tragen, und können deshalb für Schaltzwecke in diesem Bereich verwendet werden. Wegen seines verschwindenden elektrischen Widerstandes verursacht das supraleitende Material des Strombegrenzers keinerlei s2 ohmsche Verluste. Da dieser supraleitende Zustand nur unterhalb der kritischen Temperatur $T_c$, dem kritischen Strom und dem kritischen Magnetfeld auftritt, kann das supraleitende Material eines Strombegrenzers aus dem supraleitendem Zustand durch Überhöhung eines dieser Parameter über den kritischen Wert hinaus in einen resitiven Zustand übergeführt werden. Der Strombegrenzer ist in der Lage, Ströme auf einen Restwert zu begrenzen, der dann mit Hilfe eines Reststromschalters abgeschaltet werden kann. Wegen des relativ geringen elektrischen Widerstandes des supraleitenden Materials oberhalb $T_c$ ist für eine optimale Strombegrenzung ein sehr langer Leiter erforderlich, der induktivitätsarm in einem möglichst kleinen Volumen untergebracht werden muß.

Der Erfindung liegt die Aufgabe zugrunde, einen supraleitenden Strombegrenzer aufzuzeigen, dessen Leiter den Nennstrom stabil trägt, einen ausreichenden ohmschen Widerstand aufweist und einfach gekühlt werden kann.

Die Aufgabe wird erfindungsgemäß durch die Merkmale des Patentanspruches 1 gelöst.

Erfindungsgemäß ist der Leiter zum Schutz vor einer mechanischen Zerstörung und zur Halterung an einen Träger gebunden. Die Befestigung des Leiters am Träger erfolgt durch Anordnung desselben in einer Nut. Zu diesem Zweck ist der Träger auf einer oder beiden Oberflächen mit je einer Nut versehen, die eine bifilare Struktur aufweist. Die Nut ist vorzugsweise 2 mm breit und 2 mm tief. Der Leiter wird in die Nut eingelegt und über eine Wärmebehandlung dauerhaft mit dem Träger verbunden. Der Träger selbst ist aus einem keramischen oder einem metallischen Material gefertigt. Im letzteren Fall wird die Nut mit einer Isolierschicht ausgekleidet, bevor der Leiter eingesetzt wird. Diese Zwischenschicht kann auch dann angeordnet werden, wenn die Verträglichkeit zwischen dem Material des Trägers und dem Leiter zu verbessern ist.

Der Leiter kann durch Ausfüllen der Nut mit einer keramisch supraleitenden Schmelze gebildet werden. Für seine Ausbildung können auch Filamente aus supraleitendem Material oder Fasern, die mit einem supraleitenden Material überzogen und gebündelt sind, benutzt werden. Die Verwendung von Hülsen, die mit supraleitendem Material gefüllt sind, wobei die Innenflächen der Hülsen mit einem niederohmigen Metall beschichtet sind, sowie Multifilamentleiter sind ebenfalls für die Ausbildung des Leiters geeignet.

Weitere erfindungswesentliche Merkmale sind in den Unteransprüchen gekennzeichnet.

Die Erfindung wird nachfolgend anhand von schematischen Zeichnungen näher erläutert.

Es zeigen:

Fig. 1    einen erfindungsgemäßen supraleitenden Strombegrenzer,

Fig. 2    den Träger des Strombegrenzers,

Fig. 3    die Reihenschaltung von mehreren erfindungsgemäßen supraleitenden Strombegrenzern,

Fig. 4    eine Variante des in Fig. 1 dargestellten Strombegrenzers,

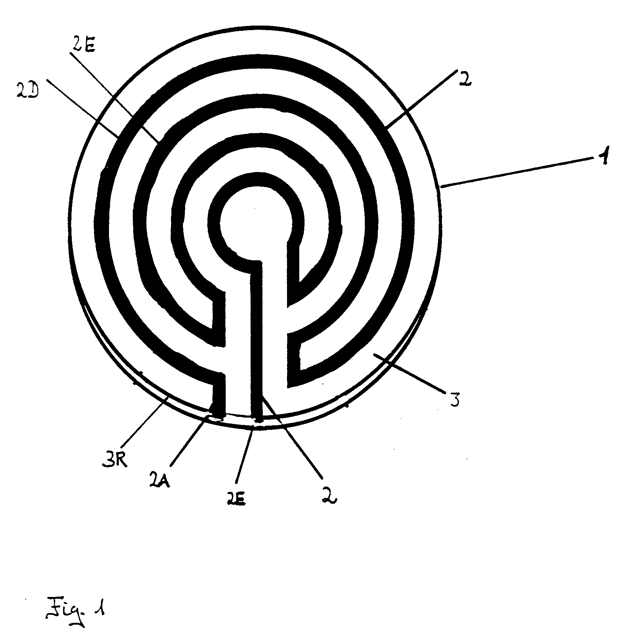

Der in Fig. 1 dargestellte Strombegrenzer 1 wird im wesentlichen durch einen elektrischen Leiter 2 und einen Träger 3 gebildet. Der hier gezeigte Leiter 2 ist vollständig aus einem keramischen supraleitenden Material hergestellt. Für die Herstellung des Leiters 2 kann z.B. Yttrium-Barium-Kupferoxid ($Y_1 Ba_2 Cu_3 O_x$) oder Wismutkuprat (BiSrCaCuO) verwendet werden. x weist dabei einen Wert von etwa 7 auf. Andere supraleitende keramische Materialien können jedoch auch Verwendung finden. Leiter, die nur teilweise aus keramischem supraleitendem Material gefertigt sind, können ebenfalls benutzt werden. Der Leiter 2 ist dauerhaft mit dem Träger 3 verbunden, und so auf diesem angeordnet, daß seine beiden Enden 2A,2E am Rand 3R des Trägers 3 in einem Abstand von etwa 6 mm angeordnet sind. Der übrige Teil des Leiters 2 ist als bifilare Spule aufgewickelt, wobei zwischen zwei unmittelbar benachbarten Leiterabschnitten 2D und 2E ein Abstand von etwa 4 mm vorgesehen ist. Der hier dargestellte Träger 3 ist aus einem keramischen Material gefertigt. Hierfür kann beispielsweise stabilisiertes Zirkoniumdioxid verwendet werden. Bei dem in Fig. 1 dargestellten Ausführungsbeispiel ist der Träger 3 als runde Scheibe ausgebildet. Er ist jedoch nicht an diese Form gebunden.

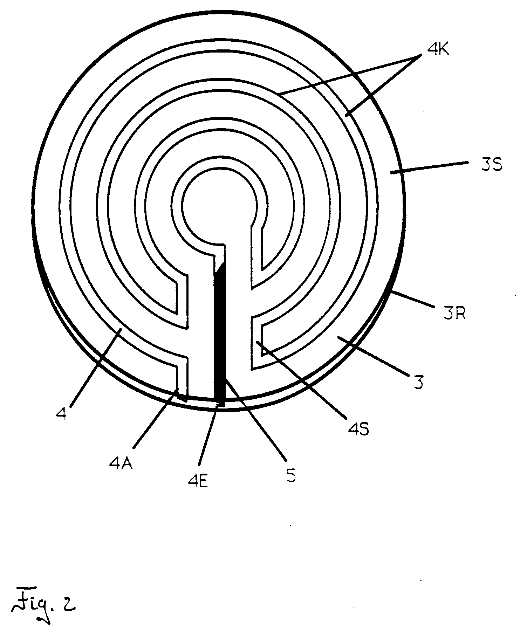

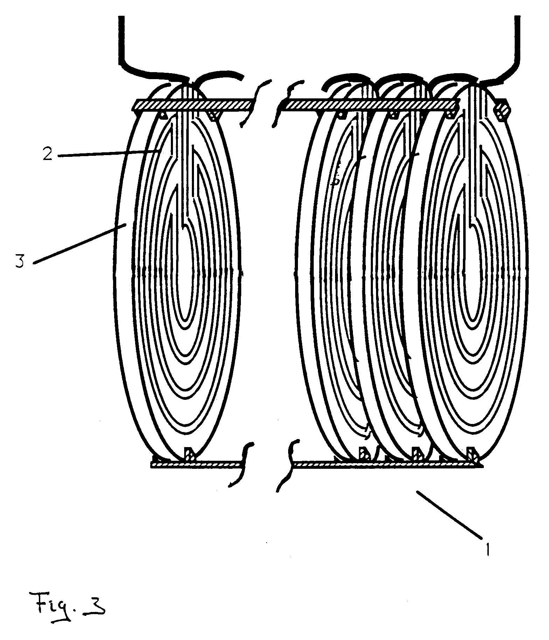

Fig. 2 zeigt den Träger 3 vor der Anordnung des Leiters 2. Die erste Oberfläche 3S des Trägers 3 weist eine zusammenhängende Nut 4 auf. Diese ist so ausgebildet, daß ihr Anfang 4A und ihr Ende 4E am äußeren Rand 3R des Trägers 3 in einem Abstand von etwa 6 mm voneinander angeordnet sind. Die Nut 4 ist in Form einer bifilaren Spule angeordnet, nämlich so, daß jeder von außen nach innen folgende Kreis 4K zum einen nicht geschlossen und zum anderen über einen Steg 4S zum nächsten ebenfalls nicht geschlossenen Kreis 4K geführt ist. Das nicht geschlossene Ende des ganz innenliegenden Kreises 4K ist bis zum Rand 3R des Trägers 3 geführt und bildet das Ende 4E der Nut 4. Die in Fig. 2 gezeigte Nut 4 ist 2 mm breit und 2 mm tief. Nach Fertigstellung der Nut 4 wird diese vollständig mit supraleitendem Material 5 ausgefüllt. Hierfür wird eines der keramischen supraleitenden Materialien 5 verwendet, die oben genannt sind bzw. ein anderes, das ähnliche oder bessere Eigenschaften aufweist. Um eine Verträglichkeit zwischem dem keramischen supraleitenden Material 5 und der Keramik des Trägers 3 sicherzustellen, kann die Nut 4 vor dem Einbringen des supraleitenden Materials 5 mit einer Schicht z.B. aus Silber, Platin oder Gold, ausgekleidet werden (hier nicht dargestellt). Das supraleitende Material 5 kann als Schmelze in die Nut 4 eingebracht werden. Anschließend wird der Träger 3 mit dem supraleitenden Material einer Wärmebehandlung unterzogen. Hierdurch wird die Haftung des supraleitenden Materials 5 in der Nut 4 sichergestellt. Vor allem erhält aber das Material des Leiters 2 hierdurch die maximal erreichbaren, supraleitenden Eigenschaften. Der in Fig. 1 dargestellte Träger 3 weist einen Durchmesser von 70 mm auf. Die Nut 4 hat eine Gesamtlänge von 400 mm, womit auch der Leiter 2 diese Länge aufweist. Ein solcher Leiter ist in der Lage, einen Nennstrom von mehr als 40 Ampere zu tragen. Um mit einem solchen supraleitenden Strombegrenzer 1 einen Widerstand von 2,5 Ohm zu bewirken, wird ein elektrischer Leiter 2 mit einem spezifischen Widerstand von 2 ($\mu$Ohm)•m und einer Länge von 5 m benötigt. Um dies zu erreichen, können, wie in Fig. 3 dargestellt, eine Vielzahl solcher Strombegrenzer 1 in Serie geschaltet werden. Hierdurch wird der gewünschte ohmsche Widerstand erzielt. Erfindungsgemäß besteht die Möglichkeit, den Träger 3 auf seinen beiden Oberflächen 3S mit je einer Nut 4 zu versehen, so daß auf einem Träger 3 durch beidseitiges Ausfüllen der jeweiligen Nut 4 jeweils ein Leiter 2 mit einer Gesamtlänge von 400 mm ausgebildet werden kann. Der Träger 3 kann anstatt aus Keramik auch aus Diamant oder einem Metall gefertigt werden. Bei der Herstellung des Trägers 3 aus Metall wird die Nut 4 vor dem Einbringen des supraleitenden Materials 5 mit einer Schicht aus Zirkoniumdioxid, Strontiumtitanat oder Diamant ausgekleidet (hier nicht dargestellt).

Zur Ausbildung des supraleitenden Strombegrenzers 1 kann auch ein Leiter 2 verwendet werden, der nur teilweise aus einem supraleitenden keramischen Material hergestellt ist. Beispielsweise eignen sich hierfür Filamente. Für deren Herstellung werden metallische Hülsen mit einem supraleitenden Material gefüllt. Anschließend wird der Durchmesser der Hülsen durch Ziehen sehr stark reduziert, so daß fadenförmige Elemente entstehen. Durch Zusammenfassen mehrerer solcher Elemente in einer weiteren Metallhülle, einem weiteren Ziehen und mehrmaligen Wiederholen dieser Schritte werden Multifilamentleiter gebildet. Filamente können jedoch auch direkt aus einer Suspension gezogen werden, die den Vorläufer des keramischen supraleitenden Material enthält. Diese Filamente werden zunächst gebündelt und gegebenenfalls verdrillt und dann in die Nut 4 eingesetzt. Dabei können die Filamente gesintert oder nur vorgesintert sein. Nach dem Einfügen der Filamente in die Nut 4 wird der Träger 3 zusammen mit den Filamenten (hier nicht dargestellt) nochmals gesintert, gleichgültig, ob die Filamente ungesintert oder vorgesintert sind. Hierdurch wird eine dauerhafte Verbindung der Filamente (hier nicht dargestellt) mit dem Träger 3 bewirkt. Ferner besteht die Möglichkeit, keramisches supraleitendes Material in eine Hülse einzufüllen. Die Hülse wird aus einem metallischen Material gefertigt, das hochohmig ist, und falls notwendig, innen eine dünne Silberschicht aufweist, die niederohmig ist. Anschließend wird diese Hülse in die Nut eingelegt und zusammen mit dem Träger zur dauerhaften Verbindung mit diesem einer Wärmebehandlung unterzogen. Ferner besteht die Möglichkeit, Fasern aus einem beliebigen Material, beispielsweise aus Kohlenstoff, mit einem supraleitenden keramischen Werkstoff zu überziehen und daraus ein Faserbündel herzustellen, das von seiner Größe her in die Nut 4 des Trägers 1 eingelegt werden kann. Durch das anschließende Sintern eines solchen Faserbündels mit dem Träger 3 wird eine dauerhafte Verbindung des Faserbündels mit dem Träger 3 bewirkt.

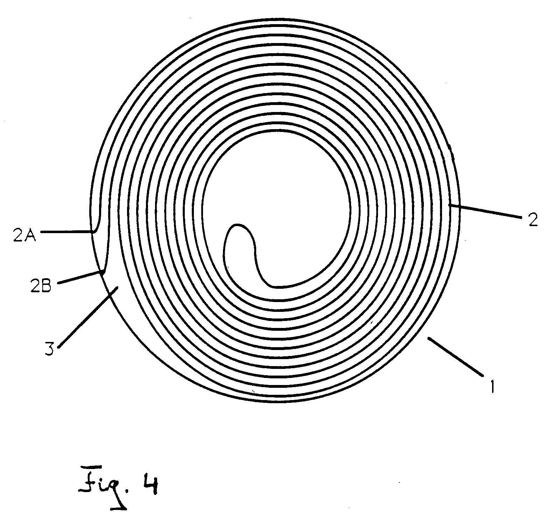

Fig. 4 zeigt eine abgewandelte Form eines Strombegrenzers 1. Gleiche Bauelemente sind mit gleichen Bezugszeichen versehen. Sein Leiter 2 ist zwar als bifilare Spule angeordnet. Diese weist jedoch eine andere Ausrichtung auf, als die in Fig. 1 dargestellte Spule. Der in Fig. 2 dargestellte Strombegrenzers 1 ist einfacher und preisgünstig herzustellen als die eingangs beschriebene Ausführungsform.

**Patentansprüche**

1. Supraleitender Strombegrenzer (1) mit wenigstens einem den Nennstrom tragenden Leiter (2),
   dadurch gekennzeichnet, daß der Leiter (2) ganz oder teilweise aus einem supraleitenden Material gefertigt und vor einer mechanischen Zerstörung geschützt ist.

2. Supraleitender Strombegrenzer nach Anspruch 1, dadurch gekennzeichnet, daß der Leiter (2) zum Schutz vor einer mechanischen Zerstörung und zur Halterung an einen Träger (3) gebunden ist.

**3.** Supraleitender Strombegrenzer nach einem der Ansprüche 1 oder 2, dadurch gekennzeichnet, daß der Träger (3) zur Aufnahme des Leiters (2) mindestens eine Nut (4) aufweist, die in Form einer bifilaren Spule auf wenigstens einer seiner Oberflächen (3S) angeordnet ist, und daß der elektrische Leiter (2) in der Nut (4) dauerhaft gehaltert ist.

**4.** Supraleitender Strombegrenzer nach einem der Ansprüche 1 bis 3, dadurch gekennzeichnet, daß der Leiter (2) durch Einfüllen einer keramisch supraleitenden Schmelze (5) in die Nut (4) gebildet ist.

**5.** Supraleitender Strombegrenzer nach einem der Ansprüche 1 bis 3, dadurch gekennzeichnet, daß der Leiter (2) aus gebündelten und supraleitenden keramischen Material gefertigten Filamenten besteht, die in die Nut (4) eingelegt und dauerhaft mit dem Träger (3) verbunden sind.

**6.** Supraleitender Strombegrenzer nach einem der Ansprüche 1 bis 3, dadurch gekennzeichnet, daß der Leiter (2) durch Fasern (5) gebildet ist, die auf ihrer Oberfläche mit einem keramischen supraleitenden Material beschichtet, gebündelt, in der Nut (4) angeordnet und dauerhaft mit dem Träger (3) verbunden sind.

**7.** Supraleitender Strombegrenzer nach einem der Ansprüche 1 bis 3, dadurch gekennzeichnet, daß der Leiter (2) aus einer in der Nut (4) angeordneten und aus hochohmigen Metall gefertigten Hülse (5)besteht, die innen mit einem niederohmigen Metall beschichtet, mit keramischem supraleitendem Material gefüllt und durch eine Wärmebehandlung dauerhaft mit dem Träger (3) verbunden ist.

**8.** Supraleitender Strombegrenzer nach einem der Ansprüche 1 bis 3, dadurch gekennzeichnet, daß der Leiter (2) ein Multifilamentleiter ist, der durch eine metallische Hülle begrenzt ist, die eine Vielzahl gebündelter mit keramischen supraleitenden Material gefüllte Hülsen aus Metall enthält.

**9.** Supraleitender Strombegrenzer nach einem der Ansprüche 1 bis 8, dadurch gekennzeichnet, daß der Träger (3) aus einem metallischen oder nicht metallischen Werkstoff gefertigt und in wenigstens eine seiner Oberflächen (3S) mindestens eine 2 mm breite und 2 mm tiefe Nut (4) zur Aufnahme des Leiters (2) bifilar spiralenartig eingearbeitet ist.

**10.** Supraleitender Strombegrenzer nach Anspruch 9, dadurch gekennzeichnet, daß der Träger (3) aus einer Keramik in Form von Zirkoniumdioxid oder Magnesiumoxid oder einem Metall, das in Bezug auf seine Wärmeausdehnung an das keramische supraleitende Material angepaßt ist, besteht, und daß die Nut (4) zur Spannungsisolierung und zur Förderung der Verträglichkeit zwischen dem Material des Leiters (2) und dem Material des Trägers (3) mit einer isolierenden Zwischenschicht aus Zirkoniumdioxid, Magnesiumdioxid, Strontiumtitanat oder Diamant, ausgekleidet ist.

**11.** Supraleitender Strombegrenzer nach einem der Ansprüche 1 bis 10, dadurch gekennzeichnet, daß die Leiter (2) von zwei oder mehreren Trägern (3) zur Bildung eines ohmschen Widerstandes definierter Größe in Serie geschaltet sind.

Fig. 1

Fig. 2

Fig. 3

Fig. 4